Europäisches Patentamt

European Patent Office

Office européen des brevets

(11) Veröffentlichungsnummer: **0 513 955 A2**

## EUROPÄISCHE PATENTANMELDUNG

(21) Anmeldenummer: **92250122.6**

(22) Anmeldetag: **13.05.92**

(51) Int. Cl.5: **G01F 1/68**, G01P 1/00, G01R 19/32, H03K 17/14

(30) Priorität: **15.05.91 DE 4116308**

(43) Veröffentlichungstag der Anmeldung:
**19.11.92 Patentblatt 92/47**

(84) Benannte Vertragsstaaten:
**AT CH DE DK FR GB IT LI NL**

(71) Anmelder: **SCHLEICHER GMBH & CO. RELAIS-WERKE KG**
**Pichelswerderstrasse 3-5**
**W-1000 Berlin 20(DE)**

(72) Erfinder: **Zuther, Friedrich F.**
**Curtiusstrasse 100**
**W-1000 Berlin 45(DE)**

(74) Vertreter: **Pfenning, Meinig & Partner**
**Kurfürstendamm 170**
**W-1000 Berlin 15(DE)**

(54) **Vorrichtung zur intermittierenden Messung einer Messgrösse über längere Zeiträume.**

(57) Es wird eine Vorrichtung zur Messung einer Meßgröße, die über längere Zeiträume intermittierend gemessen wird, vorgeschlagen. Dabei wird der Meßvorgang von einem bestimmten Ereignis ausgelöst, das die Meßgröße kurzfristig ändert. Die Vorrichtung umfaßt einen Sensor, der die Meßgröße erfaßt, und einen mit dem Sensor verbundenen Auswertekreis, der mindestens einen Komparator und/oder einen Verstärker aufweist, wobei sich das Meßsignal der Meßgröße aus einem die kurzfristige Änderung der Meßgröße darstellenden Nutzsignal und einem die Meßgröße aufgrund von Langzeitänderungen beeinflussenden Störsignal zusammensetzt und das Störsignal bei Auswertung des Meßsignals berücksichtigt wird. Vor Beginn der Messung wird das Ausgangssignal des Sensors (1) als Störsignal erfaßt und zwischengespeichert. Während der Messung wird das Störsignal als Steuergröße zum Nachführen der Schwellenspannung des Komparators (5) abhängig vom Störsignal und/oder zum Nachführen der Verstärkung des Verstärkers (10) abhängig vom Störsignal dem Komparator und/oder dem Verstärker zugeführt.

FIG.1

Die Erfindung betrifft eine Vorrichtung zur Messung einer Meßgröße, die über längere Zeiträume intermittierend gemessen wird, wobei der Meßvorgang von einem bestimmten Ereignis ausgelöst wird, das die Meßgröße kurzfristig ändert, mit einem die Meßgröße erfassenden Sensor und einem mit dem Sensor verbundenen Auswertekreis, der mindestens einen Komparator und/oder einen Verstärker aufweist, wobei sich das Meßsignal der Meßgröße aus einem die kurzfristige Änderung der Meßgröße erfassenden Nutzsignal und einem die Meßgröße aufgrund von Langzeitänderungen beeinflussenden Störsignal zusammensetzt, das bei der Auswertung des Meßsignals berücksichtigt wird.

Eine derartige Vorrichtung zur intermittierenden Messung einer Meßgröße über längere Zeiträume sind allgemein bekannt und werden für unterschiedlichste Zwecke angewandt. Aus der DE-PS 39 14 216 ist beispielsweise eine Vorrichtung zur Überwachung - der Förderung eines diskontinuierlich fließenden Mediums offenbart, bei der als Sensor ein temperaturabhängiger Widerstand verwendet wird. Bei Fließen eines Mediums, beispielsweise dem Schmiermittel in einer Zentralschmierung, ändert sich die Temperatur des Mediums an der Stelle des Sensors, wobei die Stelle des Sensors im Ruhezustand des Mediums zur Erhöhung der Temperaturänderung durch ein getrenntes Heizelement oder durch den temperaturabhängigen Widerstand erwärmt werden kann. Eine diskontinuierliche Strömung bei diesem bekannten Stand der Technik zeichnet sich dadurch aus, daß zwischen solchen Zeiten, in denen die zu erkennende Strömung besteht, längere Zeiten liegen, in denen sich das Medium in Ruhe befindet. In dieser Ruhezeit stellt sich an der Stelle des Sensors ein stationärer thermischer Zustand ein, der aber unter anderem auch von der Umgebungstemperatur abhängt. Bei dem bekannten Stand der Technik wird als Sensor ein NTC-Widerstand eingesetzt, dessen Widerstand sich bei steigender Temperatur verringert, so daß sich auch die an ihm abfallende Spannung verringert. Bei einsetzender Strömung wird der NTC-Widerstand gekühlt, wobei sich seine Temperatur verringert und sein Widerstandswert und damit auch die an ihm abfallende Spannung steigt. Ist die Umgebungstemperatur hoch, so ist auch die Ausgangsspannung, die auch Nullspannung genannt wird, des NTC-Widerstandes niedrig. Dadurch wird auch die Ausgangsspannungsänderung, die als Nutzsignal bezeichnet wird und durch die Strömung hervorgerufen wird, niedrig sein. Zur Erkennung einer Strömung bei einer derart bekannten Vorrichtung mit einem NTC-Sensor wird eine Schaltschwelle vorgegeben. Diese Schaltschwelle zum Erkennen einer definierten Strömung muß beispielsweise auf ein etwa Zehntel des Wertes bei

20° C reduziert werden, um eine Funktion auch noch bei 60° C zu gewährleisten. Durch diese Bemessung würde bei höherer Umgebungstemperatur ein nachgeschalteter Diskriminator möglicherweise nicht mehr ansprechen oder er müßte überempfindlich eingestellt werden.

In dem zitierten Stand der Technik wird eine Schaltungsanordnung vorgeschlagen, die von der Nullspannungsänderung unabhängig wird, indem die Ausgangsspannung des Sensors einem Differenzierer zugeführt wird. Langsame Änderungen dieser Spannung, wie sie typischerweise durch Änderungen der Umgebungstemperatur hervorgerufen werden, erzeugen am Ausgang dieses Differenzierers keine nennenswerte Spannung. Nur der schnelle Anstieg der Spannung, d.h. das Nutzsignal, führt zu einer gewünschten Ausgangsspannung, die einen nachfolgenden Komparator aussteuern kann. Ein solcher Differenzierer erfüllt seine Aufgabe, allerdings nur in unbefriedigender Weise. Er ist störanfällig und neigt zum Rauschen. Darüber hinaus ist seine Ausgangsspannung nicht von der Größe der Spannungsänderung abhängig, sondern von der Änderungsgeschwindigkeit, d.h. sie bildet das Nutzsignal nur indirekt ab, wenn größere Nutzsignale auch mit höherer Geschwindigkeit ansteigen.

Der Erfindung liegt somit die Aufgabe zugrunde, eine Vorrichtung zur intermittierenden Messung einer Meßgröße über längere Zeit gemäß dem Oberbegriff des Hauptanspruchs zu schaffen, die die Langzeitänderung der Meßgröße ausschalten kann, wobei die Auswertung ohne großen Aufwand an Bauteilen kostengünstig durchgeführt werden soll. Dabei soll auch eine nicht lineare Kennlinie des Sensors keine störende Rolle spielen.

Diese Aufgabe wird erfindungsgemäß durch die kennzeichnenden Merkmale des Hauptanspruchs in Verbindung mit den Merkmalen des Oberbegriffs gelöst. Dadurch, daß vor Beginn der von einem bestimmten Ereignis ausgelösten Messung das Ausgangssignal des die Meßgröße erfassenden Sensors als Störsignal erfaßt und zwischengespeichert wird und daß während der Messung das Störsignal als Steuergröße zum Nachführen der Schwellenspannung eines in der Auswerteschaltung vorhandenen Komparators verwendet wird, der die Differenz zwischen Meßsignal und Störsignal überwacht, oder daß während der Messung das Störsignal als Steuergröße zum Nachführen der Verstärkung eines Meßverstärkers dient, der die Differenz zwischen Meßsignal und Störsignal bildet, kann die Meßgröße unabhängig von Langzeitänderungen (des Nullpunktes oder der Empfindlichkeit) überwacht oder angezeigt werden.

Durch die in den Unteransprüchen angegebenen Maßnahmen sind vorteilhafte Weiterbildungen und Verbesserungen möglich. Besonders vorteilhaft ist, daß bei Vorhandensein einer Sample- und Hold-Schaltung (Abtast-Halteglied) der dort vorhandene Schalter automatisch von dem Auswertekreis derart angesteuert werden kann, daß das Meßsignal bei Beginn des Meßvorgangs festgehalten wird.

Die erfindungsgemäße Vorrichtung läßt sich für sehr viele unterschiedliche intermittierende Meßvorgänge verwenden, wobei Meßfehler, die durch langzeitige Temperaturänderungen, Spannungsänderungen oder dergleichen unabhängig von der Art der Meßgröße ausgeschaltet werden können.

Ausführungsbeispiele der Erfindung sind in der Zeichnung dargestellt und werden in der nachfolgenden Beschreibung näher erläutert. Es zeigen:

Fig. 1    ein erstes Ausführungsbeispiel eines Teils der Auswerteschaltung der erfindungsgemäßen Vorrichtung zum Messen,

Fig. 2    ein weiteres Ausführungsbeispiel der Erfindung und

Fig.3-5    weitere Ausführungsbeispiele einer Auswerteschaltung der erfindungsgemäßen Vorrichtung.

Die Erfindung soll im folgenden anhand eines ersten Ausführungsbeispiels erklärt werden, wobei es um die Überwachung der Förderung eines in einer Förderleitung diskontinuierlich fließenden Mediums geht. Das Medium ist dabei ein Schmierstoff, der in einer Zentralschmieranlage intermittierend an eine bestimmte Stelle gefördert werden muß. Dabei wird üblicherweise ein die Temperatur des Mediums erfassender Temperatursensor, beispielsweise ein NTC-Widerstand, verwendet, der direkt an der zu schmierenden Stelle montiert wird. In Abständen von einer Minute bis zu mehreren Stunden wird eine Schmierung ausgeführt, d.h. eine kleine Menge Schmierstoff wird durch das Leitungssystem gefördert. Der Sensor soll erkennen, daß diese Förderung tatsächlich stattfindet und nicht beispielsweise durch Leitungsunterbrechung oder -verstopfung verhindert wird. Dabei soll die Messung so genau sein, daß ebenfalls die Menge des geförderten Schmierstoffes bestimmt werden kann. In den Schmierpausen wird an der Stelle des Temperatursensors der Schmierstoff erwärmt, dies kann durch eine Heizquelle geschehen und bei der Förderung des Schmierstoffs fließt das Medium und der erwärmte Schmierstoff wird von dem Temperatursensor weggeführt, so daß sich an dem Sensor eine Temperaturänderung ergibt, die von ihm erfaßt wird. Wie schon im Stand der Technik erläutert wurde, hängt die Änderung des Widerstandswertes des Temperatursensors stark von der Temperatur ab, so daß die Änderung durch die Umgebungstemperatur bei dem Meßvorgang ausgeschaltet werden soll.

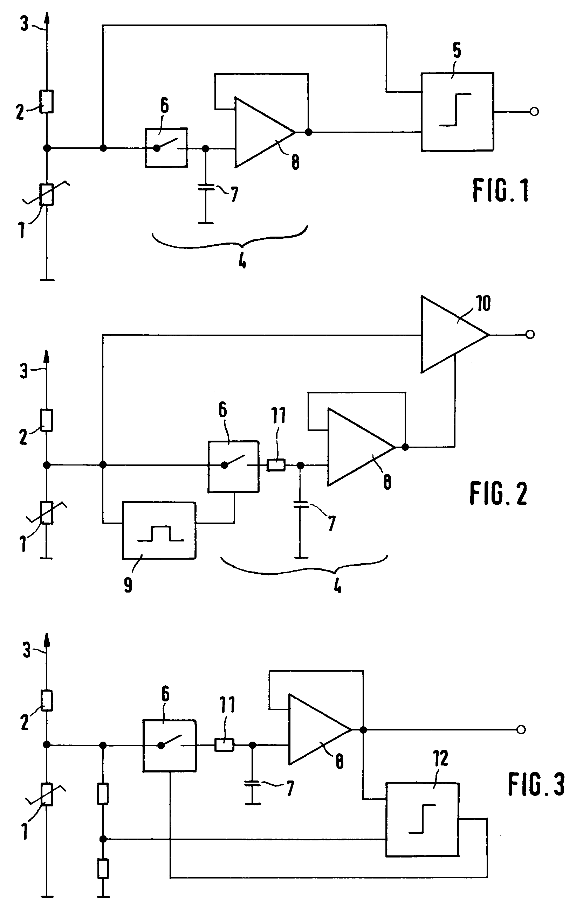

Dazu ist in Fig. 1 eine Auswerteschaltung für die Meßgröße, im vorliegenden Fall für die Temperatur dargestellt. Der Temperatursensor 1 ist in dem zu messenden Medium, beispielsweise dem Schmierstoff, angeordnet und erfaßt die Temperatur des Mediums, wobei er gleichzeitig als Heizelement für die Erwärmung des Mediums im Ruhezustand dient. Der Temperatursensor ist über einen Widerstand 2 mit einer Spannungsquelle verbunden. Der Ausgang des Temperatursensors ist an eine Abtasthalteschaltung oder auch Sample- und Hold-Schaltung 4 und an einen ersten Eingang eines Komparators 5 angeschlossen. Die Sample- and Hold-Schaltung 4 weist einen Schalter 6, einen an Masse gehenden Kondensator 7 und einen Spannungsfolger-Verstärker 8 auf. Der Ausgang des Spannungsfolgers 8 bzw. der Sample- und Hold-Schaltung 4 ist mit dem Steuereingang für den Schwellenwert des Komparators verbunden, so daß abhängig von dem Ausgangssignal der Sample- and Hold-Schaltung der Schwellenwert des Komparators 5 geändert wird.

Das grundsätzliche Prinzip der vorliegenden Erfindung liegt darin, daß das Störsignal, d.h. das die Umgebungstemperatur erfassende Signal, als sogenannte Nullspannung in den Pausen zwischen den Meßvorgängen gespeichert wird und der gespeicherte Wert als "Nullpunkt" für die jeweils folgende Messung verwendet wird. Dabei ist die in Fig. 1 dargestellte Schaltung so ausgebildet, daß zu Beginn einer Messung der Schalter 6 geöffnet wird, und das kurz vor Beginn der Messung in der Sample- und Hold-Schaltung 4 gespeicherte, die Umgebungstemperatur darstellende Störsignal während der Meßzeit am Ausgang des Spannungsfolgers 8 liegt. Während der Meßzeit wird außerdem das Ausgangssignal des Temperatursensors dem einen Eingang des Komparators 5 zugeführt. Das Ausgangssignal des Spannungsfolgers 8 steuert den Schwellenwert des Komparators, so daß die Differenz zwischen dem Störsignal, nämlich dem "Nullsignal" und dem Meßsignal während der Schmierung, das am Ausgang des Komparators 5 liegt, das Nutzsignal bildet.

Eine wesentliche Voraussetzung für den reibungslosen Betrieb der in Fig. 1 dargestellten Vorrichtung ist die Ansteuerung des Schalters 6. Diese Ansteuerung kann von einem nicht dargestellten Steuergerät, das beispielsweise die zu überwachende Strömung hervorgerufen hat, oder in einem festen Zeittakt vorgenommen werden, wobei aber der Strömungszeitpunkt und der Abgleichzeitpunkt, d.h. der Zeitpunkt des Schaltens des Schalters 6 synchronisiert werden müssen.

In den Fig. 2 und 3 ist eine automatische Steuerung für den Schalter 6 dargestellt, durch die zusätzliche Anschlüsse für eine Fernsteuerung vermieden werden und eine Synchronisation nicht notwendig ist. Dazu ist ein monostabiles Zeitglied 9 vorgesehen, dessen Ausgang den Schalter 6 steuert und dessen Eingang mit dem Ausgang des Temperatursensors 1 verbunden ist. In diesem Ausführungsbeispiel ist anstelle des Komparators 5 ein Verstärker 10 vorgesehen, der als Meßverstärker ausgebildet ist, wobei der Ausgang des Spannungsfolgers 8 als Steuergröße für den Verstärkungsfaktor des Verstärkers 10 dient. Durch die Spannungsänderung am Temperatursensor 1, die durch den Beginn einer Schmierung hervorgerufen wird, wird das monostabile Zeitglied getriggert, dessen Ausgangssignal den Schalter in den offenen Zustand steuert. Damit das am Ausgang des Spannungsfolgers 8 als Störsignal anstehende und verwendete Signal nicht durch den Spannungsanstieg, der zur Ansteuerung des monostabilen Zeitgliedes benötigt wird, verfälscht wird, ist im Vergleich zu Fig. 1 ein Widerstand 11 zwischen den Schalter 6 und den Kondensator 7 geschaltet, wodurch ein Tiefpaß gebildet wird.

Dieser Tiefpaß speichert den Spannungswert vor Öffnen des Schalters, d.h. vor Beginn des Spannungsanstieges an dem Temperatursensor 1, der den Beginn der Messung anzeigt. Anstelle des monostabilen Zeitgliedes 9 in der Fig. 2 wird in Fig. 3 ein analoger Komparator 12 vorgesehen, dessen einer Eingang mit dem Ausgang des Spannungsfolgers 8 und dessen anderer Eingang mit dem Verbindungspunkt zweier Widerstände eines Spannungsteilers 13, 14 verbunden ist, der wiederum an dem Ausgang des Temperatursensors 1 angeschlossen ist. In diesem Ausführungsbeispiel ist der zur Auswertung des Meßsignals verwendete analoge Komparator oder der Verstärker entsprechend den Fig. 1 und 2 der Einfachheit halber nicht mehr dargestellt. Der Komparator 12 vergleicht die Spannung am Ausgang des Spannungsfolgers 8 und die Spannung, die dem Ausgangssignal des Temperatursensors 1 entspricht, wobei bei Entstehung einer Differenz der Schalter 6 zum Öffnen angesteuert wird bzw. bei Verschwinden der Differenz wieder geschlossen wird.

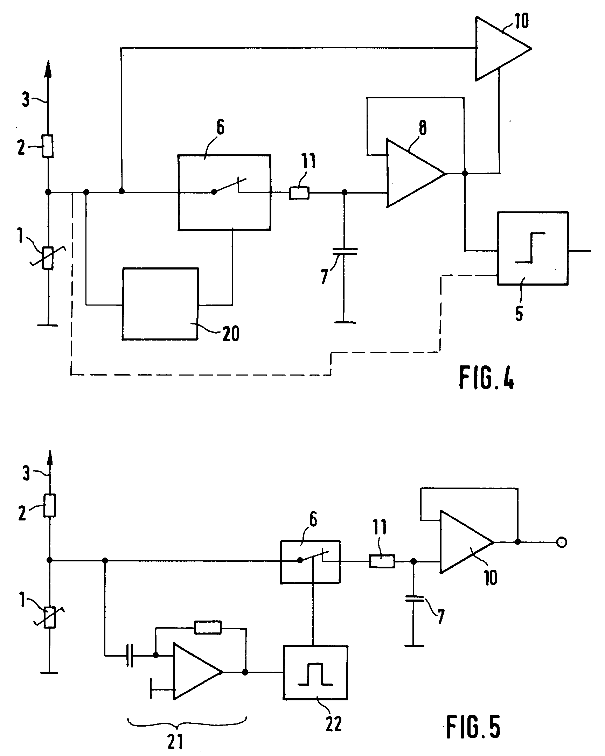

In Fig. 4 wird der Beginn einer Messung mit einem Diskriminator 20 erkannt, der den Schalter 6 steuert, während in Fig. 5 ein Differenzierer 21 vorgesehen ist, der eine Zeitschaltung 22 startet, die wiederum den Schalter 6 der Sample- und Hold-Schaltung 4 steuert.

Insgesamt kann der Speicher anstelle der Sample- und Hold-Schaltung auch als digitaler Speicher ausgeführt sein.

Bei dem oben beschriebenen Ausführungsbeispiel ist die Meßgröße die Temperatur, die mit einem Temperatursensor erfaßt wird, dessen Widerstandswert sich sowohl kurzzeitig als auch langzeitig ändert. Die erfindungsgemäße Vorrichtung berücksichtigt in Art einer analogen Schaltung die langzeitige Änderung, so daß nur das kurzzeitige Nutzsignal ausgewertet wird. Selbstverständlich sind auch andere Meßvorrichtungen mit anderen Meßgrößen, die den Gedanken der Erfindung verwenden, denkbar. So kann beispielsweise das Meßprinzip bei der Auswertung des Signals eines Dehnungsmeßstreifens verwendet werden, der beispielsweise in der Hohlkehle (Zugzone) einer Schraube angebracht wird. Die Belastungsversuche dieser Schraube werden nur jeweils innerhalb weniger Minuten durchgeführt, so daß intermittierende Messungen verwendet werden. Bei diesem Ausführungsbeispiel wird das Störsignal durch die temperaturabhängige Drift des Dehnungsmeßstreifens und durch die Änderung der Versorgungsspannung gebildet. Entsprechend den Auswerteschaltungen nach den Fig. 1 bis 5 wird das das Nutzsignal und das Störsignal enthaltende Meßsignal ausgewertet, wobei Nullpunktsfehler (aus der temperaturabhängigen Drift des Dehnungsmeßstreifens) und Empfindlichkeitsfehler (durch Änderung der Versorgungsspannung) kompensiert werden.

Eine weitere Verwendung für die Vorrichtung nach der vorliegenden Erfindung sind die Messungen bei Alarmanlagen. Hier treten nach einer langen im wesentlichen ereignislosen Zeit, in der sich die Umweltbedingungen zwar langsam aber um einen großen Betrag ändern können, schlagartige Änderungen ein. Beispielsweise kann bei Verwendung eines Infrarotwärmestrahlungssensors die langzeitige Änderung der Infrarot-Strahlung durch die Umgebung ausgeschaltet werden, so daß nur im Alarmfall die Wärmestrahlung einer unerwünschten Person erfaßt wird. Auch hier ist die Auswerteschaltung analog zu der in den Fig. 1 bis 5 angegebenen Anordnung.

Die Erfindung wurde oben unter Bezugnahme auf Temperatur, Druck und Strahlungssensoren beschrieben. Selbstverständlich sind auch andere Sensoren zur Erfassung anderer Meßgrößen anwendbar, beispielsweise Druck- und Schallsensoren oder auch Sensoren, die das Gewicht erfassen. Die Sensoren zur Erfassung des Gewichts können beispielsweise bei einer Zuschlag-Wägung angewendet werden, bei der zur Messung des Gewichts von Teilmengen das Gewicht der vorhandenen Menge als störsignal erfaßt wird und das Gewicht der neuen Menge durch Ausblenden des Gewichts der vorherigen Menge erfaßt wird.

Aus den oben beschriebenen Ausführungsbeispielen ist zu erkennen, daß die erfindungsgemäße Vorrichtung für eine Vielzahl von Meßgrößen anwendbar ist.

**Patentansprüche**

1. Vorrichtung zur Messung einer Meßgröße, die über längere Zeiträume intermittierend gemessen wird, wobei der Meßvorgang von einem bestimmten Ereignis ausgelöst wird, das die Meßgröße kurzfristig ändert, mit einem Sensor, der die Meßgröße erfaßt, und einem mit dem Sensor verbundenen Auswertekreis, der mindestens einen Komparator und/oder einen Verstärker aufweist, wobei sich das Meßsignal der Meßgröße aus einem die kurzfristige Änderung der Meßgröße darstellenden Nutzsignal und einem die Meßgröße aufgrund von Langzeitänderungen beeinflussenden Störsignal zusammensetzt und das Störsignal bei Auswertung des Meßsignals berücksichtigt wird,

**dadurch gekennzeichnet,**

daß zu Beginn der Messung das Ausgangssignal des Sensors (1) als Störsignal erfaßt und zwischengespeichert wird und daß während der Messung das Störsignal als Steuergröße zum Nachführen der Schwellenspannung des Komparators (5) abhängig vom Störsignal und/oder zum Nachführen der Verstärkung des Verstärkers (10) abhängig vom Störsignal dem Komparator (5) und/oder dem Verstärker (10) zugeführt wird.

2. Vorrichtung nach Anspruch 1, dadurch gekennzeichnet, daß der Sensor (1) sowohl mit dem Komparator(5) und/oder Verstärker (10) als auch mit einem Analogwert-Speicher, bestehend aus Schalter (6), Kondensator (7) und Verstärker (8), verbunden ist, wobei der Ausgang der Sample- und Hold-Schaltung mit dem Steuereingang für die Schwellenspannung des Komparators (5) und/oder für die Verstärkung des Verstärkers (10) verbunden ist.

3. Vorrichtung nach Anspruch 1 oder 2, dadurch gekennzeichnet, daß eine Steuereinrichtung vorgesehen ist, die ein Steuersignal für die intermittierende Messung in vorgegebenen festen Zeiträumen abgibt.

4. Vorrichtung nach Anspruch 3, dadurch gekennzeichnet, daß der Schalter (6) der Sample- und Hold-Schaltung (4) abhängig von dem Steuersignal öffnet.

5. Vorrichtung nach einem der Ansprüche 1 bis 3, dadurch gekennzeichnet, daß eine Schaltung (9,12) zur Erfassung des Beginns der intermittierenden Messung vorgesehen ist und daß das Ausgangssignal der Schaltung den Schalter (6) der Sample- und Hold-Schaltung (4) in die Offenstellung steuert.

6. Vorrichtung nach einem der Ansprüche 1 bis 5, dadurch gekennzeichnet, daß die Sample- und Hold-Schaltung einen Tiefpaß (7,11) aufweist.

7. Vorrichtung nach Anspruch 5 oder 6, dadurch gekennzeichnet, daß die Schaltung zur Erfassung des Beginns der intermittierenden Messung ein Zeitglied (9) aufweist, das durch die Änderung der Meßgröße getriggert wird und dessen Ausgangssignal den Schalter (6) der Sample- und Hold-Schaltung (4) in den offenen Zustand steuert.

8. Vorrichtung nach Anspruch 5 oder 6, dadurch gekennzeichnet, daß die Schaltung zur Erfassung des Beginns der intermittierenden Messung einen Komparator (12) aufweist, dessen Eingänge jeweils mit dem Eingang und dem Ausgang der Sample- und Hold-Schaltung verbunden sind und dessen Ausgangssignale den Schalter (6) steuert.

9. Vorrichtung nach einem der Ansprüche 1 bis 8, dadurch gekennzeichnet, daß der Sensor (1) mit Konstantstrom gespeist wird.

10. Vorrichtung nach einem der Ansprüche 1 bis 9, dadurch gekennzeichnet, daß die Schaltung zum Feststellen des Beginns einer Messung einen Diskriminator oder einen Differenzierer aufweist.

FIG.1

FIG.2

FIG.3

FIG.4

FIG.5